# EUROPEAN PATENT SPECIFICATION

(11) **EP 1 665 375 B1**
(45) Date of publication and mention of the grant of the patent: **21.10.2009**
(21) Application number: 04779798.0
(22) Date of filing: 03.08.2004
(51) Int. Cl.: H01L 23/29, C08L 63/00, C01B 33/14

(54) **SOLVENT-MODIFIED RESIN COMPOSITIONS AND METHODS OF USE THEREOF**
LÖSUNGSMITTEL-MODIFIZIERTE HARZ-ZUSAMMENSETZUNGEN UND VERWENDUNGSVERFAHREN DAFÜR
COMPOSITIONS DE RESINE MODIFIEES PAR SOLVANT ET LEURS PROCEDES D'UTILISATION

(30) Priority: 03.09.2003 US 654378; 16.12.2003 US 737943
(43) Date of publication of application: 07.06.2006
(73) Proprietor: Momentive Performance Materials Inc., Albany, NY 12211 (US)
(72) Inventor: RUBINSZTAJN, Slawomir, Niskayuna, NY 12309 (US); TONAPI, Sandeep, Niskayuna, NY 12309 (US); GIBSON, David, Alexander, III, Scotia, NY 12302 (US); CAMPBELL, John, Robert, Clifton Park, NY 12065 (US); PRABHAKUMAR, Ananth, Chandler, AZ 85226 (US); MILLS, Ryan, Christopher, Rexford, NY 12148 (US)
(74) Representative: Herrmann, Uwe
(86) International application number: PCT/US2004/024847
(87) International publication number: WO 2005/024938

(56) References cited:
- WO-A-03/101164
- WO-A-20/04048266
- DATABASE CA [Online] CHEMICAL ABSTRACTS SERVICE, COLUMBUS, OHIO, US; MATSUMOTO, MAKOTO ET AL: "Epoxy resin-silicone putting compositions" XP002305943 retrieved from STN Database accession no. 118:104162 -& JP 04 154861 A (TOSHIBA SILICONE CO., LTD., JAPAN) 27 May 1992 (1992-05-27)

## Description

### BACKGROUND OF THE INVENTION

The present disclosure relates to solvent-modified resin compositions and transparent materials such as underfill materials made therefrom. More specifically, the solvent-modified resin composition includes a thermosetting resin, at least one solvent, and functionalized colloidal silica. The final cured composition has a low coefficient of thermal expansion and a high glass transition temperature.

Demand for smaller and more sophisticated electronic devices continues to drive the electronic industry towards improved integrated circuit packages that are capable of supporting higher input/output (I/O) density as well as have enhanced performance at smaller die areas. While flip chip technology has been developed to respond to these demanding requirements, a weak point of the flip chip construction is the significant mechanical stress experienced by solder bumps during thermal cycling due to the coefficient of thermal expansion (CTE) mismatch between silicon die and substrate. This mismatch, in turn, causes mechanical and electrical failures of the electronic devices. Currently, capillary underfill is used to fill gaps between silicon chip and substrate and improve the fatigue life of solder bumps; however capillary underfill based fabrication processes introduce additional steps into the chip assembly process that reduce productivity.

Ideally, underfill resins would be applied at the wafer stage to eliminate manufacturing inefficiencies associated with capillary underfill. However, use of resins containing conventional fused silica fillers needed for low CTE is problematic because fused silica fillers obscure guide marks used for wafer dicing and also interfere with the formation of good electrical connections during solder reflow operations. Thus, in some applications improved transparency is needed to enable efficient dicing of a wafer to which underfill materials have been applied.

Thus, an improved underfill material having low CTE and improved transparency would be desirable.

### BRIEF DESCRIPTION OF THE INVENTION

The present disclosure relates to a composition comprising at least one curable aromatic epoxy resin, at least one solvent, a filler of colloidal silica, and at least one selected from the group consisting of cycloaliphatic epoxy monomer, aliphatic epoxy monomer, hydroxy aromatic compounds, and combinations and mixtures thereof. The present disclosure also relates to transparent underfill compositions comprising at least one curable resin in combination with a solvent, a filler of colloidal silica that is functionalized with at least one organoalkoxysilane and at least one selected from the group consisting of cycloaliphatic epoxy monomer, aliphatic epoxy monomer, hydroxy aromatic compounds, and combinations and mixtures thereof. Preferably, the resin utilized in the composition forms a hard, transparent B-stage resin upon removal of solvent, and then forms a low CTE, high Tg thermoset resin upon curing.

The underfill material is made by a method of combining a heated filler suspension and solvent with the resin and optional additives, forming a B-stage resin by removing solvent and re-heating the resin to cure the material and thus form a low CTE, high Tg thermoset resin.

### DETAILED DESCRIPTION OF THE INVENTION

The present disclosure is related to solvent-modified resin compositions that are useful as underfill materials. The solvent-modified resin compositions include a resin matrix of at least one aromatic epoxy resin and at least one cycloaliphatic epoxy resin, aliphatic epoxy resin or hydroxy aromatic compounds, or mixtures or combinations thereof. The resin matrix is combined with at least one solvent, and a particle filler dispersion. In one embodiment, the aromatic epoxy resin is an epoxy derived from novolac cresol resin. In another embodiment, the particle filler dispersion comprises at least one functionalized colloidal silica. The solvent-modified resin composition may also include one or more hardeners and/or catalysts, among other additives. Upon heating and removal of solvent, the combination forms a transparent B-stage resin. After removal of the solvent, the underfill materials are finally curable by heating to a transparent cured, hard resin with low coefficient of thermal expansion ("CTE"), and high glass transition temperature ("Tg"). The colloidal silica filler is essentially uniformly distributed throughout the disclosed compositions, and this distribution remains stable at room temperature and during removal of solvent and any curing steps. The transparency of the resulting resin is useful as an underfill material, especially a wafer level underfill, to render wafer dicing guide marks visible during wafer dicing operations. In certain embodiments, the underfill material can have self-fluxing capabilities.

"Low coefficient of thermal expansion" as used herein refers to a cured total composition with a coefficient of thermal expansion lower than that of the base resin as measured in parts per million per degree centigrade (ppm/°C). Typically, the coefficient of thermal expansion of the cured total composition is below about 50 ppm/°C. "Cured" as used herein refers to a total formulation with reactive groups wherein between about 50% and about 100% of the reactive groups have reacted. "B-stage resin" as used herein refers to a secondary stage of thermosetting resins in which resins are typically hard and may have only partially solubility in common solvent. "Glass transition temperature" as referred to herein is the temperature as which an amorphous material changes from a hard to a plastic state. "Low viscosity of the total composition before cure" typically refers to a viscosity of the underfill material in a range between about 50 centipoise and about 100,000 centipoise and preferably, in a range between about 200 centipoise and about 20,000 centipoise at 25°C before the composition is cured. "Transparent" as used herein refers to a maximum haze percentage of 15, typically a maximum haze percentage of ten (10); and most typically a maximum haze percentage of three (3).

Suitable resins for use in the solvent-modified resin compositions include, but are not limited to epoxy resins, polydimethylsiloxane resins, acrylate resins, other organo-functionalized polysiloxane resins, polyimide resins, fluorocarbon resins, benzocyclobutene resins, fluorinated polyallyl ethers, polyamide resins, polyimidoamide resins, phenol cresol resins aromatic polyester resins, polyphenylene ether (PPE) resins, bismaleimide triazine resins, fluororesins and any other polymeric systems known to those skilled in the art which may undergo curing to a highly crosslinked thermoset material. (For common polymers, see "Polymer Handbook", Branduf, J.,; Immergut, E.H; Grulke, Eric A; Wiley Interscience Publication, New York, 4th ed.(1999); "Polymer Data Handbook"; Mark, James, Oxford University Press, New York (1999)). Preferred curable thermoset materials are epoxy resins, acrylate resins, polydimethyl siloxane resins and other organo-functionalized polysiloxane resins that can form cross-linking networks via free radical polymerization, atom transfer, radical polymerization, ring-opening polymerization, ring-opening metathesis polymerization, anionic polymerization, cationic polymerization or any other method known to those skilled in the art. Suitable curable silicone resins include, for example, the addition curable and condensation curable matrices as described in "Chemistry and Technology of Silicone"; Noll, W., Academic Press (1968).

The epoxy resin is preferably an epoxy resin matrix including at least one aromatic epoxy resin and at least one cycloaliphatic epoxy monomer, aliphatic epoxy monomer, or hydroxy aromatic compound, or a mixture of any one of the above. The epoxy resins may further include any organic system or inorganic system with an epoxy functionality. When resins, including aromatic, aliphatic and cycloaliphatic resins are described throughout the specification and claims, either the specifically-named resin or molecules having a moiety of the named resin are envisioned. Useful epoxy resins include those described in "Chemistry and Technology of the Epoxy Resins," B.Ellis (Ed.) Chapman Hall 1993, New York and "Epoxy Resins Chemistry and Technology," C. May and Y. Tanaka, Marcell Dekker, New York (1972). Epoxy resins are curable monomers and oligomers which can be blended with the filler dispersion. The epoxy resins may include an aromatic epoxy resin or an alicyclic epoxy resin having two or more epoxy groups in its molecule. The epoxy resins in the composition of the present disclosure preferably have two or more functionalities, and more preferably two to four functionalities. Useful epoxy resins also include those that could be produced by reaction of a hydroxyl, carboxyl or amine containing compound with epichlorohydrin, preferably in the presence of a basic catalyst, such as a metal hydroxide, for example sodium hydroxide. Also included are epoxy resins produced by reaction of a compound containing at least one and preferably two or more carbon-carbon double bonds with a peroxide, such as a peroxyacid.

The aromatic epoxy resins useful in the epoxy resin matrix preferably have two or more epoxy functionalities, and more preferably two to four epoxy functionalities. Addition of these materials will provide a resin composition with higher glass transition temperatures (Tg). Examples of aromatic epoxy resins useful in the present disclosure include cresol-novolac epoxy resins, bisphenol-A epoxy resins, bisphenol-F epoxy resins, phenol novolac epoxy resins, bisphenol epoxy resins, biphenyl epoxy resins, 4,4'-biphenyl epoxy resins, polyfunctional epoxy resins, divinylbenzene dioxide, and 2-glycidylphenylglycidyl ether. Examples of trifunctional aromatic epoxy resins include triglycidyl isocyanurate epoxy, VG3101L manufactured by Mitsui Chemical and the like, and examples of tetrafunctional aromatic epoxy resins include by Araldite MTO163 manufactured by Ciba Geigy and the like. In one embodiment, preferred epoxy resins for use with the present disclosure include cresol-novolac epoxy resins, and epoxy resins derived from bisphenols.

The multi-functional epoxy monomers are included in the composition of the present disclosure in amounts ranging from about 1% by weight to about 70% by weight of the total composition, with a range of from about 5% by weight to about 35% by weight being preferred. In some cases the amount of epoxy resin is adjusted to correspond to molar amount of other reagents such as novolac resin hardeners.

Cycloaliphatic epoxy resins useful in the compositions of the present invention are well known to the art and, as described herein, are compounds that contain at least about one cycloaliphatic group and at least one oxirane group. In one embodiment, epoxides of cycloaliphatic olefins are preferred. More preferred cycloaliphatic epoxies are compounds that contain about one cycloaliphatic group and at least two oxirane rings per molecule. Specific examples include 3-(1,2-epoxyethyl)-7-oxabicyclo heptane; hexanedioic acid, bis(7-oxabicyclo heptylmethyl) ester; 2-(7-oxabicyclohept-3-yl)-spiro(1,3-dioxa-5,3'-(7)-oxabicycloheptane; methyl 3,4-epoxycyclohexane carboxylate, 3-cyclohexenylmethyl-3-cyclohexenylcarboxylate diepoxide, 2-(3,4-epoxy)cyclohexyl-5,5-spiro-(3,4-epoxy)cyclohexane-m-dioxane, 3,4-epoxycyclohexylalkyl-3,4-epoxycyclohexanecarboxylate, 3,4-epoxy-6-methylcyclohexylmethyl-3,4-epoxy-6-methylcyclohexanecarboxylate, vinyl cyclohexanedioxide, bis(3,4-epoxycyclohexylmethyl)adipate, bis(3,4-epoxy-6-methylcyclohexylmethyl)adipate, exo-exo bis(2,3-epoxycyclopentyl) ether, endo-exo bis(2,3-epoxycyclopentyl) ether, 2,2-bis(4-(2,3-epoxypropoxy)cyclohexyl)propane, 2,6-bis(2,3-epoxypropoxycyclohexyl-p-dioxane), 2,6-bis(2,3-epoxypropoxy)norbomene, the diglycidylether of linoleic acid dimer, limonene dioxide, 2, 2-bis(3,4-epoxycyclohexyl)propane, dicyclopentadiene dioxide, 1,2-epoxy-6-(2,3-epoxypropoxy)-hexahydro-4, 7-methanoindane, p-(2,3-epoxy)cyclopentylphenyl-2,3-epoxypropylether, 1-(2,3-epoxypropoxy)phenyl-5, 6-epoxyhexahydro-4, 7-methanoindane, o-(2,3-epoxy)cyclopentylphenyl-2, 3-epoxypropyl ether), 1,2-bis(5-(1,2-epoxy)-4, 7-hexahydromethanoindanoxyl)ethane, cyclopentenylphenyl glycidyl ether, cyclohexanediol diglycidyl ether, butadiene dioxide, dimethylpentane dioxide, diglycidyl ether, 1,4-butanedioldiglycidyl ether, diethylene glycol diglycidyl ether, and dipentene dioxide, and diglycidyl hexahydrophthalate. Typically, the cycloaliphatic epoxy resin is 3-cyclohexenylmethyl -3-cyclohexenylcarboxylate diepoxide

The cycloaliphatic epoxy monomers are included in the solvent-modified resin composition in amounts ranging from about 0.3 % by weight to about 15 % by weight of the total composition, with a range of from about 0.5 % by weight to about 10 % by weight being preferred.

Aliphatic epoxy resins useful in the solvent-modified resin compositions include compounds that contain at least one aliphatic group, including C₄-C₂₀ aliphatic resins or polyglycol type resins. The aliphatic epoxy resin may be either monofunctional, i.e. one epoxy group per molecule, or polyfunctional, i.e. two or more epoxy groups per molecule. Examples of aliphatic epoxy resins include but at not limited to, butadiene dioxide, dimethylpentane dioxide, diglycidyl ether, 1, 4-butanedioldiglycidyl ether, diethylene glycol diglycidyl ether, and dipentene dioxide.

Such aliphatic epoxy resins are available commercially, such as DER 732 and DER 736 from Dow.

The aliphatic epoxy monomers are included in the solvent-modified resin composition in amounts ranging from about 0.3 % by weight to about 15 % by weight of the total composition, with a range of from about 0.5 % by weight to about 10 % by weight being preferred.

Silicone-epoxy resins may be utilized and can be of the formula:

MₐM'_{b}D_{c}D'_{d}TₑT'_{f}Q_{g}

where the subscripts a, b, c, d, e, f and g are zero or a positive integer, subject to the limitation that the sum of the subscripts b, d and f is one or greater; where M has the formula:

R¹₃SiO_{1/2},

M' has the formula:

(Z)R²₂SiO_{1/2},

D has the formula:

R³₂SiO_{2/2},

D' has the formula:

(Z)R⁴SiO_{2/2},

T has the formula:

R⁵SiO_{3/2},

T' has the formula:

(Z)SiO_{3/2},

and Q has the formula SiO_{4/2}, where each R¹, R², R³, R⁴, R⁵ is independently at each occurrence a hydrogen atom, C₁₋₂₂alkyl, C₁₋₂₂alkoxy, C2₋₂₂alkenyl, C₆₋₁₄aryl, C₆₋₂₂ alkyl-substituted aryl, and C₆₋₂₂arylalkyl which groups may be halogenated, for example, fluorinated to contain fluorocarbons such as C₁₋₂₂ fluoroalkyl, or may contain amino groups to form aminoalkyls, for example aminopropyl or aminoethylaminopropyl, or may contain polyether units of the formula (CH₂CHR⁶O)ₖ where R⁶ is CH₃ or H and k is in a range between about 4 and 20; and Z, independently at each occurrence, represents an epoxy group. The term "alkyl" as used in various embodiments of the present disclosure is intended to designate both normal alkyl, branched alkyl, aralkyl, and cycloalkyl radicals. Normal and branched alkyl radicals are preferably those containing in a range between about 1 or about 12 carbon atoms, and include as illustrative non-limiting examples methyl, ethyl, propyl, isopropyl, butyl, tertiary-butyl, pentyl, neopentyl, and hexyl. Cycloalkyl radicals represented are preferably those containing in a range between about 4 and about 12 ring carbon atoms. Some illustrative non-limiting examples of these cycloalkyl radicals include cyclobutyl, cyclopentyl, cyclohexyl, methylcyclohexyl, and cycloheptyl. Preferred aralkyl radicals are those containing in a range between about 7 and about 14 carbon atoms; these include, but are not limited to, benzyl, phenylbutyl, phenylpropyl, and phenylethyl. Aryl radicals used in the various embodiments of the present disclosure are preferably those containing in a range between about 6 and about 14 ring carbon atoms. Some illustrative non-limiting examples of these aryl radicals include phenyl, biphenyl, and naphthyl. An illustrative non-limiting example of a halogenated moiety suitable is trifluoropropyl. Combinations of epoxy monomers and oligomers are also contemplated for use with the present disclosure.

Suitable solvents for use with the resin include, for example, 1-methoxy-2-propanol, methoxy propanol acetate, butyl acetate, methoxyethyl ether, methanol, ethanol, isopropanol, ethyleneglycol, ethylcellosolve, methylethyl ketone, cyclohexanone, benzene, toluene, xylene, and cellosolves such as ethyl acetate, cellosolve acetate, butyl cellosolve acetate, carbitol acetate, and butyl carbitol acetate. These solvents may be used either singly or in the form of a combination of two or more members. In one embodiment, a preferred solvent for use with this disclosure is 1-methoxy-2-propanol. The solvent is present in the solvent-modified resin composition in an amount of from about 5 weight percent to about 70 weight percent, preferably about 15 weight percent to about 40 weight percent, and ranges there between.

The filler utilized to make the modified fillers in the composition of the present disclosure is preferably a colloidal silica which is a dispersion of submicron-sized silica (SiO₂) particles in an aqueous or other solvent medium. The dispersion contains at least about 10 weight percent and up to about 85 weight percent of silicon dioxide (SiO₂), and typically between about 30 weight percent to about 60 weight percent of silicon dioxide. The particle size of the colloidal silica is typically in a range between 50 nanometers (nm) and 100 nm.

The colloidal silica is functionalized with an organoalkoxysilane to form a functionalized colloidal silica, as described below.

Organoalkoxysilanes used to functionalize the colloidal silica are included within the formula:

(R⁷)ₐSi(OR⁸)₄₋ₐ,

where R⁷ is independently at each occurrence a C₁₋₁₈ monovalent hydrocarbon radical optionally further functionalized with alkyl acrylate, alkyl methacrylate or epoxide groups or C₆₋₁₄ aryl or alkyl radical, R⁸ is independently at each occurrence a C₁₋₁₈ monovalent hydrocarbon radical or a hydrogen radical and "a" is a whole number equal to 1 to 3 inclusive. Preferably, the organoalkoxysilanes included in the present disclosure are phenyl trimethoxysilane, 2-(3,4-epoxy cyclohexyl)ethyltrimethoxysilane, 3-glycidoxypropyltrimethoxysilane, and methacryloxypropyltrimethoxysilane. In a preferred embodiment, phenyl trimethoxysilane can be used to functionalize the colloidal silica. In yet another embodiment, phenyl trimethoxysilane is used to functionalize the colloidal silica. A combination of functionalities is also possible.

Typically, the organoalkoxysilane is present in a range between about 0.5 weight % and about 60 weight % based on the weight of silicon dioxide contained in the colloidal silica, preferably from about 5 weight % to about 30 weight %.

The functionalization of colloidal silica may be performed by adding the functionalization agent to a commercially available aqueous dispersion of colloidal silica in the weight ratio described above to which an aliphatic alcohol has been added. The resulting composition comprising the functionalized colloidal silica and the functionalization agent in the aliphatic alcohol is defined herein as a pre-dispersion. The aliphatic alcohol may be selected from, but not limited to, isopropanol, t-butanol, 2-butanol, and combinations thereof. The amount of aliphatic alcohol is typically in a range between about 1 fold and about 10 fold of the amount of silicon dioxide present in the aqueous colloidal silica pre-dispersion.

The resulting organofunctionalized colloidal silica can be treated with an acid or base to neutralize the pH. An acid or base as well as other catalyst promoting condensation of silanol and alkoxysilane groups may also be used to aid the functionalization process. Such catalysts include organo-titanate and organo-tin compounds such as tetrabutyl titanate, titanium isopropoxybis(acetylacetonate), dibutyltin dilaurate, or combinations thereof. In some cases, stabilizers such as 4-hydroxy-2,2,6,6-tetramethylpiperidinyloxy (i.e. 4-hydroxy TEMPO) may be added to this pre-dispersion. The resulting pre-dispersion is typically heated in a range between about 50°C and about 100°C for a period in a range between about 1 hour and about 5 hours.

The cooled transparent pre-dispersion is then further treated to form a final dispersion. Optionally curable monomers or oligomers may be added and optionally, more aliphatic solvent which may be selected from but not limited to isopropanol, 1-methoxy-2-propanol, 1-methoxy-2-propyl acetate, toluene, and combinations thereof. This final dispersion of the functionalized colloidal silica may be treated with acid or base or with ion exchange resins to remove acidic or basic impurities.

The final dispersion composition can be hand-mixed or mixed by standard mixing equipment such as dough mixers, chain can mixers, and planetary mixers. The blending of the dispersion components can be performed in batch, continuous, or semi-continuous mode by any means used by those skilled in the art.

This final dispersion of the functionalized colloidal silica is then concentrated under a vacuum in a range between about 0.5 Torr and about 250 Torr and at a temperature in a range between about 20°C. and about 140°C. to substantially remove any low boiling components such as solvent, residual water, and combinations thereof to give a transparent dispersion of functionalized colloidal silica which may optionally contain curable monomer, here referred to as a final concentrated dispersion. Substantial removal of low boiling components is defined herein as removal of low boiling components to give a concentrated silica dispersion containing from about 15% to about 80% silica.

B-staging typically occurs at a temperature in a range between about 50°C and about 250°C, more typically in a range between about 70°C and about 100°C, in a vacuum at a pressure ranging between about 25 mmHg and about 250mmHg, and more preferably between about 100 mmHg and about 200mmHg. In addition, curing may typically occur over a period of time ranging from about 30 minutes to about 5 hours, and more typically in a range between about 45 minutes and about 2.5 hours. Optionally, the cured resins can be post-cured at a temperature in a range between about 100°C and about 250°C, more typically in range between about 150°C and about 200°C over a period of time ranging from about 45 minutes to about 3 hours.

The resulting composition preferably contains functionalized silicon dioxide as the functionalized colloidal silica. In such a case, the amount of silicon dioxide in the final composition can range from about 15% to about 80% by weight of the final composition, more preferably from about 25% to about 75% by weight, and most preferably from about 30% to about 70% by weight of the final cured resin composition. The colloidal silica filler is essentially uniformly distributed throughout the disclosed composition, and this distribution remains stable at room temperature.

As used herein "uniformly distributed" means the absence of any visible precipitate with such dispersions being transparent.

In some instances, the pre-dispersion or the final dispersion of the functionalized colloidal silica may be further functionalized. Low boiling components are at least partially removed and subsequently, an appropriate capping agent that will react with residual hydroxyl functionality of the functionalized colloidal silica is added in an amount in a range between about 0.05 times and about 10 times the amount of silicon dioxide present in the pre-dispersion or final dispersion. Partial removal of low boiling components as used herein refers to removal of at least about 10% of the total amount of low boiling components, and preferably, at least about 50% of the total amount of low boiling components.

An effective amount of capping agent caps the functionalized colloidal silica and capped functionalized colloidal silica is defined herein as a functionalized colloidal silica in which at least 10%, preferably at least 20%, more preferably at least 35%, of the free hydroxyl groups present in the corresponding uncapped functionalized colloidal silica have been functionalized by reaction with a capping agent.

In some cases capping the functionalized colloidal silica effectively improves the cure of the total curable resin formulation by improving room temperature stability of the resin formulation. Formulations which include the capped functionalized colloidal silica show much better room temperature stability than analogous formulations in which the colloidal silica has not been capped in some cases.

Exemplary capping agents include hydroxyl reactive materials such as silylating agents. Examples of a silylating agent include, but are not limited to hexamethyldisilazane (HMDZ), tetramethyldisilazane, divinyltetramethyldisilazane, diphenyltetramethyldisilazane, N-(trimethylsilyl)diethylamine, 1-(trimethylsilyl)imidazole, trimethylchlorosilane, pentamethylchlorodisiloxane, pentamethyldisiloxane, and combinations thereof. In a preferred embodiment, hexamethyldisilazane is used as the capping agent. Where the dispersion has been further functionalized, e.g. by capping, at least one curable monomer is added to form the final dispersion. The dispersion is then heated in a range between about 20°C and about 140°C for a period of time in a range between about 0.5 hours and about 48 hours. The resultant mixture is then filtered. The mixture of the functionalized colloidal silica in the curable monomer is concentrated at a pressure in a range between about 0.5 Torr and about 250 Torr to form the final concentrated dispersion. During this process, lower boiling components such as solvent, residual water, byproducts of the capping agent and hydroxyl groups, excess capping agent, and combinations thereof are substantially removed to give a dispersion of capped functionalized colloidal silica containing from about 15% to about 75% silica.

Optionally, an epoxy hardener such as an amine epoxy hardener, a phenolic resin, a carboxylic acid-anhydride, or a novolac hardener may be added. Additionally, cure catalysts or organic compounds containing hydroxyl moiety are optionally added with the epoxy hardener.

Exemplary amine epoxy hardeners typically include aromatic amines, aliphatic amines, or combinations thereof. Aromatic amines include, for example, m-phenylene diamine, 4,4'-methylenedianiline, diaminodiphenylsulfone, diaminodiphenyl ether, toluene diamine, dianisidene, and blends of amines. Aliphatic amines include, for example, ethyleneamines, cyclohexyldiamines, alkyl substituted diamines, menthane diamine, isophorone diamine, and hydrogenated versions of the aromatic diamines. Combinations of amine epoxy hardeners may also be used. Illustrative examples of amine epoxy hardeners are also described in "Chemistry and Technology of the Epoxy Resins" B. Ellis (Ed.) Chapman Hall, New York, 1993.

Exemplary phenolic resins typically include phenol-formaldehyde condensation products, commonly named novolac or cresol resins. These resins may be condensation products of different phenols with various molar ratios of formaldehyde. Such novolac resin hardeners include those commercially available such as Tamanol 758 or HRJ1583 oligomeric resins available from Arakawa Chemical Industries and Schenectady International, respectively. Additional examples of phenolic resin hardeners are also described in "Chemistry and Technology of the Epoxy Resins" B. Ellis (Ed.) Chapman Hall, New York, 1993. While these materials are representative of additives used to promote curing of the epoxy formulations, it will apparent to those skilled in the art that other materials such as but not limited to amino formaldehyde resins may be used as hardeners and thus fall within the scope of this invention.

Suitable hydroxy aromatic compounds are those that do not interfere with the resin matrix of the present composition. Such hydroxy-containing monomers may include hydroxy aromatic compounds represented by the following formula: 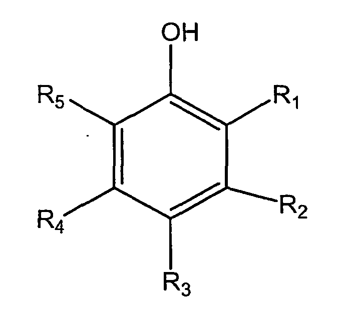 wherein R1 to R5, is independently a C₁-C₁₀ branched or chain aliphatic or aromatic group, or hydroxyl. Examples of such hydroxyl aromatic compounds include, but are not limited to, hydroquinone, resorcinol, catechol, methylhydroquinone, methyl resorcinol and methyl catechol. If present, the hydroxy aromatic compounds are present in an amount of from about about 0.3 weight percent to about 15 weight percent, and preferably, about 0.5 to about 10 weight percent.

Exemplary anhydride curing agents typically include methylhexahydrophthalic anhydride (MHHPA), methyltetrahydrophthalic anhydride, 1,2-cyclohexanedicarboxylic anhydride, bicyclo[2.2.1]hept-5-ene-2,3-dicarboxylic anhydride, methylbicyclo[2.2.1]hept-5-ene-2,3-dicarboxylic anhydride, phthalic anhydride, pyromellitic dianhydride, hexahydrophthalic anhydride, dodecenylsuccinic anhydride, dichloromaleic anhydride, chlorendic anhydride, tetrachlorophthalic anhydride, and the like. Combinations comprising at least two anhydride curing agents may also be used. Illustrative examples are described in "Chemistry and Technology of the Epoxy Resins"; B. Ellis (Ed.) Chapman Hall, New York, (1993) and in "Epoxy Resins Chemistry and Technology"; edited by C.A. May, Marcel Dekker, New York, 2nd edition, (1988).

Cure catalysts which can be added to form the epoxy formulation can be selected from typical epoxy curing catalysts that include but are not limited to amines, alkyl-substituted imidazole, imidazolium salts, phosphines, metal salts such as aluminum acetyl acetonate (A1(acac)3), salts of nitrogen-containing compounds with acidic compounds, and combinations thereof. The nitrogen-containing compounds include, for example, amine compounds, di-aza compounds, tri-aza compounds, polyamine compounds and combinations thereof. The acidic compounds include phenol, organo-substituted phenols, carboxylic acids, sulfonic acids and combinations thereof. A preferred catalyst is a salt of nitrogen-containing compounds. Salts of nitrogen-containing compounds include, for example 1,8-diazabicyclo(5,4,0)-7-undecane. The salts of the nitrogen-containing compounds are available commercially, for example, as Polycat SA-1 and Polycat SA-102 available from Air Products. Preferred catalysts include triphenyl phosphine (TPP), N-methylimidazole (NMI), and dibutyl tin dilaurate (DiBSn).

Examples of organic compounds utilized as the hydroxyl-containing moiety include alcohols such as diols, high boiling alkyl alcohols containing one or more hydroxyl groups and bisphenols. The alkyl alcohols may be straight chain, branched or cycloaliphatic and may contain from 2 to 12 carbon atoms. Examples of such alcohols include but are not limited to ethylene glycol; propylene glycol, i.e., 1,2- and 1,3-propylene glycol; 2,2-dimethyl-1,3-propane diol; 2-ethyl, 2-methyl, 1,3-propane diol; 1,3- and 1,5-pentane diol; dipropylene glycol; 2-methyl-1, 5-pentane diol; 1,6-hexane diol; dimethanol decalin, dimethanol bicyclo octane; 1,4-cyclohexane dimethanol and particularly its cis- and trans-isomers; triethylene glycol; 1,10-decane diol; and combinations of any of the foregoing. Further examples of diols include bisphenols.

Some illustrative, non-limiting examples of bisphenols include the dihydroxy-substituted aromatic hydrocarbons disclosed by genus or species in U.S. Patent No. 4,217,438. Some preferred examples of dihydroxy-substituted aromatic compounds include 4,4'-(3,3,5-trimethylcyclohexylidene)-diphenol; 2,2-bis(4-hydroxyphenyl)propane (commonly known as bisphenol A); 2,2-bis(4-hydroxyphenyl)methane (commonly known as bisphenol F); 2,2-bis(4-hydroxy-3,5-dimethylphenyl)propane; 2,4'-dihydroxydiphenylmethane; bis(2-hydroxyphenyl)methane; bis(4-hydroxyphenyl)methane; bis(4-hydroxy-5-nitrophenyl)methane; bis(4-hydroxy-2,6-dimethyl-3-methoxyphenyl)methane; 1,1-bis(4-hydroxyphenyl)ethane; 1, 1-bis(4-hydroxy- 2-chlorophehyl ethane; 2,2-bis(3-phenyl-4-hydroxyphenyl)propane; bis(4-hydroxyphenyl)cyclohexylmethane; 2,2-bis(4-hydroxyphenyl)-1-phenylpropane; 2,2,2',2'-tetrahydro-3,3,3',3'-tetramethyl,1'-spirobi[1H-indene]-6,6'-diol (SBI); 2,2-bis(4-hydroxy-3-methylphenyl)propane (commonly known as DMBPC); and C₁-₁₃ alkyl-substituted resorcinols. Most typically, 2,2-bis(4-hydroxyphenyl)propane and 2,2-bis(4-hydroxyphenyl)methane are the preferred bisphenol compounds. Combinations of organic compounds containing hydroxyl moiety can also be used in the present disclosure.

A reactive organic diluent may also be added to the total curable epoxy formulation to decrease the viscosity of the composition. Examples of reactive diluents include, but are not limited to, 3-ethyl-3-hydroxymethyl-oxetane, dodecylglycidyl ether, 4-vinyl-1-cyclohexane diepoxide, di(Beta-(3,4-epoxycyclohexyl)ethyl)-tetramethyldisiloxane, and combinations thereof. Reactive organic diluents may also include monofunctional epoxies and/or compounds containing at least one epoxy functionality. Representative examples of such diluents include, but are not limited to, alkyl derivatives of phenol glycidyl ethers such as 3-(2-nonylphenyloxy)-1,2-epoxypropane or 3-(4-nonylphenyloxy)-1,2-epoxypropane. Other diluents which may be used include glycidyl ethers of phenol itself and substituted phenols such as 2-methylphenol, 4-methyl phenol, 3-methylphenol, 2-butylphenol, 4-butylphenol, 3-octylphenol, 4-octylphenol, 4-t-butylphenol, 4-phenylphenol and 4-(phenylisopropylidene)phenol.

Adhesion promoters can also be employed with the total final dispersion such as trialkoxyorganosilanes (e.g., γ-aminopropyltrimethoxysilane, 3-glycidoxypropyltrimethoxysilane, and bis(trimethoxysilylpropyl)fumarate). Where present, the adhesion promoters are added in an effective amount which is typically in a range between about 0.01% by weight and about 2% by weight of the total final dispersion.

Flame retardants can be optionally used in the total final dispersion in a range between about 0.5 weight % and about 20 weight % relative to the amount of the total final dispersion. Examples of flame retardants include phosphoramides, triphenyl phosphate (TPP), resorcinol diphosphate (RDP), bisphenol-a-disphosphate (BPA-DP), organic phosphine oxides, halogenated epoxy resin (tetrabromobisphenol A), metal oxide, metal hydroxides, and combinations thereof.

In addition to the epoxy resin matrix described, two or more epoxy resins may be used in combination for the aromatic epoxy resin e.g., a mixture of an alicyclic epoxy and an aromatic epoxy. Such a combination improves transparency and flow properties. It is preferable to use an epoxy mixture containing at least one epoxy resin having three or more functionalities, to thereby form an underfill resin having low CTE, good fluxing performance, and a high glass transition temperature. The epoxy resin can include a trifunctional epoxy resin, in addition to at least a difunctional alicyclic epoxy and a difunctional aromatic epoxy.

Methods for producing the compositions of the present disclosure result in improved underfill materials. In one embodiment, compositions are prepared by functionalizing colloidal silica such that a stable concentrated dispersion of colloidal silica is formed; forming a concentrated dispersion of functionalized colloidal silica containing about 15% to about 75% silica; blending solutions of epoxy monomers including at least one cycloaliphatic epoxy resin and at least one aliphatic epoxy resin, and optionally one or more additives such as hardeners, catalysts or other additives described above, and at least one solvent with the functionalized colloidal silica dispersion; removing the solvent to form a hard, transparent B-stage resin film; and curing the B-stage resin film. Such a process is useful in forming a low CTE, high Tg thermoset resin.

Thus, the solvent-modified epoxy resin is useful in producing both B-stage resin films and low CTE, high Tg thermoset resins produced after curing the B-stage resin films. The transparency of the B-stage resin films produced in accordance with the present disclosure makes them especially suitable as wafer level underfill materials as they do not obscure guide marks used for wafer dicing. In addition, the B-stage resin films provide good electrical connections during solder reflow operations resulting in low CTE, high Tg thermoset resins after curing.

It has been surprisingly found that by following the methods of the present disclosure, one can obtain underfill materials with good flow properties having elevated levels of functionalized colloidal silica that are not otherwise obtainable by current methods.

Underfill materials as described in the present disclosure are dispensable and have utility in devices such as but not limited to solid state devices and/or electronic devices such as computers or semiconductors, or any device where underfill, overmold, or combinations thereof are needed. The underfill material can be used as a wafer level underfill and/or encapsulant to reinforce physical, mechanical, and electrical properties of solder bumps that typically connect a chip and a substrate. The disclosed underfill material exhibits enhanced performance and advantageously has lower manufacturing costs. Underfilling may be achieved by any method known in the art. The preferred method is wafer level underfill. The wafer level underfilling process includes dispensing underfill materials onto the wafer before dicing into individual chips that are subsequently mounted in the final structure via flip-chip type operations. The composition of the present disclosure has the ability to fill gaps ranging from about 10 microns to about 600 microns.

In order that those skilled in the art will be better able to practice the present disclosure, the following examples are given by way of illustration and not by way of limitation.

### EXAMPLE I

Preparation of functionalized colloidal silica (FCS) predispersion. A functionalized colloidal silica predispersion was prepared by combining the following: 935g of isopropanol (Aldrich) was slowly added by stirring to 675 grams of aqueous colloidal silica (Nalco 1034A, Nalco Chemical Company) containing 34 weight % of 20 nm particles of SiO₂. Subsequently, 58.5g phenyl trimethoxysilane (PTS) (Aldrich), which was dissolved in 100g isopropanol, was added to the stirred mixture. The mixture was then heated to 80°C for 1-2 hours to afford a clear suspension. The resulting suspension of functionalized colloidal silica was stored at room temperature. Multiple dispersions, having various levels of SiO₂ (from 10% to 30%) were prepared for use in Example 2.

EXAMPPreparation of dispersion of a functionalized colloidal silica in epoxy resin. A round bottom 2000 ml flask was charged with 540 g of each of the pre-dispersions, prepared in Example 1. Additional pre-dispersion compositions are shown in Table 1, below. 1-methoxy-2-propanol (750g) was then added to each flask. The resulting dispersin of functionalized colloidal silica was vacuum stripped at 60°C and 60 mmHg to remove about 1L of solvents. The vacuum was slowly decreased and solvent removal continued with good agitation until the dispersion weight had reached 140g. The clear dispersion of phenyl-functionalized colloidal silica contained 50% SiO₂ and no precipitated silica. This dispersion was stable at room temperature for more than three months. The results in Table 1 show that a certain level of phenyl functionality is required in order to prepare a concentrated, stable FCS dispersion in 1-methoxy-2-propanol (Dispersion 1 through 5). The functionality level can be adjusted to achieve a clear, stable dispersion in methoxypropanol acetate. This adjustment indicated that optimization of functionality level permitted dispersions to be prepared in other solvents (Dispersions 6 and 7).

**Table 1**

| Preparation of FCS Dispersions | | | |
|---|---|---|---|
| Entry# | Pre-dispersion Composition | Final Dispersion Concentration | Dispersion Stability |
| | (PTS*/100g SiO2) | (wt% SiO2)/wt% total solids) | (in methoxypropanol) |
| I | 0.028m/100g | 50% Si02/63% | precipitated |
| 2 | 0.056m/100g | 47% SiO2/60% | precipitated |
| 3 | 0.13m/100g | 53%SiO2/66% | stable, clear |
| 4 | 0.13m/100g | 60%SiO2/75% | stable, clear |
| 5 | 0.19m/100g | 50% Si02/63% | stable, clear |
| | | | (in methoxy propanol acetate) |
| 6 | 0.13m/100g | 50% Si02/63% | precipitated |
| 7 | 0.19m/100g | 50% Si02/63% | stable, clear |

| | | | |
|---|---|---|---|
| *PTS is phenyltrimethoxysilane | | | |

### EXAMPLE 3

Preparation of a dispersion of capped functionalized colloidal silica in epoxy resin. A solution combining 5.33g of epoxy cresol novolac (ECN 195XL-25 available from Sumitomo Chemical Co.), 2.6g of novolac hardener (Tamanol 758 available from Arakawa Chemical Industries) in 3.0g of 1-methoxy-2-propanol was heated to about 50°C. A 7.28g portion of the solution was added, dropwise, to 10.0g of the FCS dispersion, by stirring at 50°C (see, Table 1, entry #3, 50% SiO₂ in methoxypropanol, above). The clear suspension was cooled and a catalyst solution of N-methylimidazole, 60 microliters of a 50% w/w solution in methoxypropanol was added by stirring. The clear solution was used directly to cast resin films for characterization or stored at -10°C. Additional films were prepared using differing catalysts in various amounts and some variations in the epoxy as set forth in Table 2 below which shows final resin compositions.

Films were cast by spreading a portion of the epoxy-silica dispersion on glass plates, and the solvent was removed in an oven set at 85°C under a vacuum of 150 mmHg. After 1-2 hours, the glass plates were removed and the film remaining was clear and hard. In some cases, the dry film was cured at 220°C for 5 minutes followed by heating at 160°C for 60 minutes. Glass transition temperature measurements were obtained by Differential Scanning Calorimetry using a commercially available DSC from Perkin Elmer. The formulations tested and their Tg are set forth below in Table 2.

**Table 2**

| Colloidal Silica Formulations | | | | | | |
|---|---|---|---|---|---|---|
| Entry # | Epoxy (g)* | Hardener**(g) | Solvent*** (g) | Catalyst**** (g) | FCS amount***** | Tg****** |
| 1 | ECN (3.55) | T758 (1.73) | MeOPrOH(2) | TPP (0.12) | 10 | 168 |
| 2 | ECN (3.55) | T758 (1.73) | MeOPrOH(2) | TPP (0.06) | 10 | 165 |
| 3 | ECN (3.55) | T758 (1.73) | MeOPrOH(2) | NMI(0.015) | 10 | 199 |
| 4 | ECN (3.55) | T758 (1.73) | MeOPrOH(2) | NMI(0.018) | 5 | 180 |
| 5 | ECN (3.55) Epon 1002F (0.5) | T758 (1.73) | MeOPrOH(2) | TPP (0.06) | 10 | 136 |
| 6 | ECN (3.55) Epon 1002F (0.5) | T758 (1.73) | MeOPrOH(2) | NMI(0.03) | 10 | 184 |
| 7 | ECN (3.55) | T758 (1.73) | BuAc(2) | TPP(0.12) | 5 | 171 |
| 8 | ECN (3.55) | T758 (1.73) | diglyme(2) | TPP (0.12) | 5 | 171 |
| 9 | ECN (3.55) | T758 (1.73) | BuAc(2) | DiBSn (0.12) | 5 | 104 |

| | | | | | | |
|---|---|---|---|---|---|---|
| * ECN refers to ECN 195XL-25 available form Sumitomo Chemical Co. and Epon 1002F refers to an oligomerized BPA diglycidyl ether epoxy available from Resolution Performance Products. ** T758 refers to Tamanol 758 available from Arakawa Chemical Industries *** Solvents are 1-methoxy-2-propanol(MeOPrOH), butyl acetate (BuAc) or methoxyethyl ether (diglyme) **** Catalysts are triphenyl phosphine (TPP), N-methylimidazole (NMI) or dibutyl tin dilaurate (DiBSn) ***** FCS amount refers to the amount in grams of 50% SiO₂ phenyl functionalized colloidal silica described in Example 2. ****** Tg refers to the glass transition temperature as measured by DSC (mid-point of inflection). | | | | | | |

### EXAMPLE 4

The coefficient of thermal expansion performance of wafer level underfill (WLU) materials was determined. 10 micron films of the material, prepared as per Example 3 were cast on Teflon slabs (with the dimensions 4"x4"x0.25") and dried at 40°C and 100 mmHg overnight to give a clear hard film, which was then further dried at 85°C and 150 mmHg. The film was cured according to the method of Example 3 and coefficient of thermal expansion (CTE) values measured by thermal mechanical analysis (TMA). The samples were cut to 4mm width using a surgical blade and the CTE was measured using a thin film probe on the TMA.

Thermal Mechanical Analysis was performed on a TMA 2950 Thermo Mechanical Analyzer from TA Instruments. Experimental parameters were set at: 0.05N of force, 5.000g static weight, nitrogen purge at 100 mL/min, and 2.0 sec/pt sampling interval. The sample was equilibrated at 30°C for 2 minutes, followed by a ramp of 5.00 °C/min to 250.00 °C, equilibrated for 2 minutes, then ramped 10.00 °C/min to 0.00 °C, equilibrated for 2 minutes, and then ramped 5.00 °C/min to 250.00 °C.

Table 3 below provides the CTE data obtained. The results for the second and third entries in Table 3 were obtained on films that were transparent, in contrast to films generated from the same compositions in which 5 micron fused silica was used. Both the 5 micron fused silica and the functionalized colloidal silica were used at the same loading rate of 50 weight %. Moreover, the reduction in CTE exhibited by these materials (Table 3, second and third entries) over the unfilled resin. (Table 3, entry 1) indicates that the functionalized colloidal silica is effective in reducing resin CTE.

**Table 3**

| | CTE below T_{g} | CTE Above T_{g} |
|---|---|---|
| Entry # | (µm/m°C) | (µm/m°C) |
| unfilled resin | 70 | 210 |
| Table 2, Entry 1 | | |
| (TPP level 0.015g) | 46 | 123 |
| Table 3, Entry 3 | | |
| (NMI level 0.0075g) | 40 | 108 |

### EXAMPLE 5

Solder wetting and reflow experiments. The following experiments were carried out in order to demonstrate the wetting action of solder bumps in the presence of the wafer level underfill, as prepared in Examples above.

### Part A:

Bumped flip chip dies were coated with a layer of the experimental underfill material from Example 3. This underfill coating contained a substantial amount of solvent, about 30%. In order to drive off this solvent, the coated chips were baked in a vacuum oven at 85°C and 150 mmHg. This resulted in the tip of the solder bumps being exposed, and a B-stage resin layer coated the entire active surface of the chip.

### Part B:

To ensure that the wetting ability of the solder bumps was not hindered by the presence of this B-stage layer, a thin coating of flux was applied to a Cu-clad FR-4 coupon (a glass epoxy sheet laminated with copper commercially available from MG Chemicals). The flux (Kester TSF 6522 Tacflux) was applied only in the area where the solder bumps would contact the copper surface. This assembly was then subjected to reflow in a Zepher convection reflow oven (MannCorp). After reflow, the dies were manually sheared off, and inspected for wet-out solder on the copper surface.

Molten solder that had wet the copper surface remained adhered to the board, indicating that the wetting ability, in the presence of tacky flux, was not hindered by the B-staged layer of wafer level underfill material.

### Part C:

Coated chips were prepared using the methodology described in Part A. These chips were assembled on to a test board, with a daisy chain test pattern. The test board used was a 62 mil thick FR-4 board commercially available from MG Chemicals. The pad finish metallurgy was Ni/Au. Tacky flux (Kester TSF 6522) was syringe dispensed onto the exposed pads on the test board, using a 30 gauge needle tip and an EFD manual dispenser (EFD, Inc.). The dies were placed on the board with the help of an MRSI 505 automatic pick and place machine (Newport/MSRI Corp.). This assembly was then subjected to reflow in a Zepher convection reflow oven. Electrical resistance readings of ∼2 ohms (measured with a Fluke multimeter) indicated that the solder had wet the pads in the presence of the wafer level underfill. X-ray analysis of the chip assembly attached to the Cu pads for both a control die and a die coated with the composition of the present disclosure was conducted utilizing an X-ray machine having a MICROFOCUS X-ray tube. The results of the X-ray analysis indicated solder wetting of the Cu pads, in that the solder bumps showed similar solder ball morphology for both the control and experimental resins after reflow.

### EXAMPLE 6

Preparation of functionalized colloidal silica (FCS) predispersion. A functionalized colloidal silica predispersion was prepared by combining the following: 1035g of isopropanol (Aldrich) was slowly added by stirring to 675 grams of aqueous colloidal silica (Snowtex OL, Nissan Chemical Company) containing 20-21 weight % of 50 nm particles of SiO₂. Subsequently, 17.6g phenyl trimethoxysilane (PTS) (Aldrich), was added to the stirred mixture. The mixture was then heated to 80°C for 1-2 hours to afford a pre-dispersion of functionalized colloidal silica that was stored at room temperature.

### EXAMPLE 7

Preparation of dispersion of a functionalized colloidal silica in solvents. A round bottom 2000 ml flask was charged with 540 g of each of the pre-dispersions, prepared in Example 6. Additional pre-dispersion compositions are shown in Table 4, below. 1-methoxy-2-propanol (750g) was then added to each flask. The resulting dispersion of functionalized colloidal silica was vacuum stripped at 60°C and 60 mmHg to remove about 1L of solvents. The vacuum was slowly decreased and solvent removal continued with good agitation until the dispersion weight had reached 80g. The dispersion of phenyl-functionalized colloidal silica contained 50% SiO₂ and no precipitated silica. This dispersion was stable at room temperature for more than three months. The results in Table 4 show that a certain level of phenyl functionality is required in order to prepare a concentrated, stable FCS dispersion in 1-methoxy-2-propanol (Dispersions 1-4,6). A composition from Example 2, Table 1 entry 3 (listed on Table 4 at entry 6) is included for comparison.

**Table 4**

| Entry# | Pre-dispersion Composition | Final Dispersion Concentration(size) | Dispersion Stability |
|---|---|---|---|
| | (PTS/100g SiO2) | (wt% SiO2) | (in methoxypropanol) |
| 1 | 0.067m/100g | 47% Si02 - 50nm | Marginally stable |
| 2 | 0.0838m/100g | 50% SiO2 - 50nm | Stable |
| 3 | 0.134/100g | 50%SiO2 - 50nm | Stable |
| 4 | 0.268m/100g | 50%SiO2 - 50nm | Stable |
| 5 | 0.134/100g | 47%SiO2 - 50nm | Stable |
| 6 | 0.134/100g | 50%SiO2 - 20nm | Stable |

### EXAMPLE 8

Preparation of a dispersion of functionalized colloidal silica in epoxy resin. A solution combining 5.33g of epoxy cresol novolac (ECN 195XL-25 available from Sumitomo Chemical Co.), 2.6g of novolac hardener (Tamanol 758 available from Arakawa Chemical Industries) in 3.0g of 1-methoxy-2-propanol was heated to about 50°C. A 7.28g portion of the solution was added, dropwise, to 10.0g of the FCS dispersion, by stirring at 50°C (see, Table 4, entry #3, 50% SiO₂ in methoxypropanol, above). The clear suspension was cooled and a catalyst solution of N-methylimidazole, 60 microliters of a 50% w/w solution in methoxypropanol was added .by stirring. The clear solution was used directly to cast resin films for characterization or stored at -10°C. Additional films were prepared using differing catalysts in various amounts and variations in the epoxy/hardener composition and various FCS dispersions as set forth in Table 5 below which shows final resin compositions.
Films were cast by spreading a portion of the epoxy-silica dispersion on glass plates, and the solvent was removed in vacuum oven at 90C/200mm for 1 hour and 90C/100mm for an additional hour. The glass plates were removed and the remaining film was a clear and solid B-stage material. In some cases, the dry film was cured at 220°C for 5 minutes followed by heating at 160°C for 60 minutes. Glass transition temperature measurements were obtained by Differential Scanning Calorimetry using a commercially available DSC from Perkin Elmer. The results of DSC analysis are set forth below in Table 6.

**Table 5**

| Sample# | Filler* (Wt % SiO2) | Epoxy A (g)** | Epoxy B (g)** | Hardener A (g)*** | Hardener B (g)*** | Methoxypropanol (g) | Catalyst (%)**** |
|---|---|---|---|---|---|---|---|
| 1 | 0 | ECN(5.3) | - | Tamanol (2.6) | - | 3 | 0.14 |
| 2 | Denka 40 | ECN(5.3) | - | Tamanol (2.6) | - | 3 | 0.14 |
| 3 | Table 4, | ECN(5.3) | - | Tamanol | - | 3 | 0.14 |
| | #6 (50) | | | (2.6) | | | |
| 4 | Table 4, | ECN(5.3) | - | Tamanol | - | 3 | 0.14 |
| | #6 (10) | | | (2.6) | | | |
| 5 | Table 4, | ECN(5.3) | - | Tamanol | - | 3 | 0.14 |
| | #6 (15) | | | (2.6) | | | |
| 6 | Table 4, | ECN(5.3) | - | Tamanol | - | 3 | 0.14 |
| | #1 (20) | | | (2.6) | | | |
| 7 | Table 4, | ECN(5.3) | - | Tamanol | - | 3 | 0.14 |
| | #1 (30) | | | (2.6) | | | |
| 8 | Table 4, | ECN(5.0) | UVR6105 | HRJ (2.6) | - | 3 | 0.14 |
| | #1 (30) | | (0.475) | | | | |
| 9 | Table 4, | ECN(5.0) | UVR6105 | HRJ (2.6) | - | 3 | 0.14 |
| | #1 (60) | | (0.475) | | | | |
| 10 | Table 4, | ECN(4.5) | UVR6105 | HRJ (2.6) | - | 3 | 0.14 |
| | #1 (50) | | (0.945) | | | | |
| 11 | Table 4, | ECN(4.0) | UVR6105 | HRJ (2.6) | - | 3 | 0.14 |
| | #1 (50) | | (1.52) | | | | |
| 12 | Table 4, | ECN(4.9) | - | Tamanol | - | 2.7 | 0.14 |
| | #5 (10) | | | (2.4) | | | |
| 13 | Table 4, | ECN(4.9) | - | Tamanol | - | 2.7 | 0.14 |
| | #5 (20) | | | (2:4) | | | |
| 14 | Table 4, | ECN(4.9) | - | Tamanol | - | 2.7 | 0.14 |
| | #5 (30) | | | (2.4) | | | |
| 15 | Table 4, | ECN(4.9) | - | Tamanol | - | 2.7 | 0.14 |
| | #5 (40) | | | (2.4) | | | |
| 16 | Table 4, | ECN(4.9) | - | Tamanol | - | 2.7 | 0.14 |
| | #5 (50) | | | (2.4) | | | |
| 17 | Table 4, | ECN (2.2) | DER 732 | Tamanol | - | 1.4 | 0.14 |
| | #5 (50) | | (0.4) | (1.2) | | | |
| 18 | Table 4, | ECN (2.2) | DER 736 | Tamanol | - | 1.4 | 0.14 |
| | #5 (50) | | (0.3) | (1.2) | | | |
| 19 | Table4, | ECN(2.8) | - | Tamanol | Hydroquinone | 1.6 | 0.14 |
| | #5 (30) | | | (1.1) | (0.5) | | |
| 20 | Table 4, | ECN(2.4) | - | Tamanol | Hydroquinone | 1.3 | 0.14 |
| | #5 (40) | | | (0.9) | (0.5) | | |
| 21 | Table 4, | ECN(2.8) | - | Tamanol | Resorcinol | 1.6 | 0.14 |
| | #5 (30) | | | (1.1) | (0.5) | | |
| 22 | Table 4, | ECN(2.4) | - | Tamanol | Resorcinol | 1.3 | 0.14 |
| | #5 (40) | | | (0.9) | (0.5) | | |

| | | | | | | | |
|---|---|---|---|---|---|---|---|
| *Filler refers to the weight of SiO₂ in the final formulation in the form of functionalized colloidal silica as described in Table 4. The filler specified as Denka is a 5 micron fused silica filler (FB-5LDX) available from Denka Corporation. ** ECN refers to ESCN 195XL-25 available form Sumitomo Chemical Co. Epoxy B is UVR6105, 3-cyclohexenylmethyl-3-cyclohexenylcarboxylate diepoxide available from Dow Chemical Co. DER 732 is a polyglycol diepoxide available from Dow Chemical Co. DER 736 is a polyglycol diepoxide available from Dow Chemical Co. *** Hardeners are Tamanol 758 or HRJ1583 oligomeric resins available from Arakawa Chemical Industries and Schenectady International respectively or monomeric hydroquinone or resorcinol purchased from Aldrich Chemical. ****Catalyst (N-methylimidazole) loading is based on organic components excluding solvent | | | | | | | |

### Example 9:

Flow performance of 50nm Functionalized colloidal silica formulations. Resin films containing lead eutectic solder balls were prepared by casting a film of resin compositions described in Table 5 onto glass slides. Lead eutectic solder balls (25 mil diameter, mp 183C) were placed in this film by compressing two glass slides together to insure that the balls were immersed in the resin film. These assemblies were then heated in an oven at 90C/200mm for 1 hour and 90C/100mm for an additional hour to remove all solvent and convert the resin film into a hard, B-stage film with embedded solder balls. The films, when cooled to ambient temperature were generally hard as noted in Table 6. A test of the resin flow and fluxing capability was performed by placing the glass slide onto copper clad FR-4 circuit board onto which a drop of Kester flux (product TSF-6522 available from the Kester division of Northrup Grumman) had been placed. The glass slide was positioned such that the solder ball/resin film was in contact with the flux. The entire assembly was then placed onto a hot plate that was maintained at 230-240°C. Flow and fluxing performance was considered to be good if the solder balls exhibited collapse and flowed together. In contrast, resins with poor flow and fluxing characteristics prevented solder ball collapse and the original solder ball morphology was clearly evident visually. Good flow and flux performance to enable solder ball melting and collapse is considered to be critical to forming good electrical connections in a device and the test described above is a measure of utility in device fabrication.
The results summarized in Table 6 indicate that films with substantially improved clarity can be prepared with 50 nm functionalized colloidal silica (entries 6,7 and 12-16) versus compositions based on conventional 5 micron filler (entry 2) although the films while of acceptable clarity are not as clear as with compositions based on 20 nm functionalized colloidal silica (entries 3-5). However, unexpectedly, the addition of small amounts of a cycloaliphatic epoxy monomer, UVR 6105, gives films with excellent clarity even at high loadings of 50 nm functionalized colloidal silica (entries 8-11). Moreover, the results of entries 8-11 show that film hardness is preserved over a range of UVR 6105 levels.

**Table 6**

| Sample # | Material | T_{g}* | B-stage** | Clarity*** | Solder ball collapse**** |
|---|---|---|---|---|---|
| 1 | Table 5, #1 | 190 | hard | Clear | Complete (excellent) |
| 2 | Table 5, #2 | 193 | hard | opaque | Complete (excellent) |
| 3 | Table 5, #3 | 184 | hard | Clear | No collapse, very poor |
| 4 | Table 5, #4 | 185 | hard | Clear | Complete (good) |
| 5 | Table 5, #5 | - | hard | Clear | Marginal, poor |
| 6 | Table 5, #6 | - | hard | Translucent | Complete (excellent) |
| 7 | Table 5, #7 | 180 | hard | Translucent | Marginal, acceptable |
| 8 | Table 5, #8 | 158 | hard | Clear | Complete (excellent) |
| 9 | Table 5, #9 | 153 | hard | Clear | Complete (excellent) |
| 10 | Table 5, #10 | 160 | hard | Clear | Complete (excellent) |
| 11 | Table 5, #11 | 157 | tacky | Clear | Complete (excellent) |
| 12 | Table 5, #12 | 183 | hard | Translucent | Complete (excellent) |
| 13 | Table 5, #13 | 183 | hard | Translucent | Complete (excellent) |
| 14 | Table 5, #14 | 187 | hard | Translucent | Complete (excellent) |
| 15 | Table 5, #15 | 190 | hard | Translucent | Marginal, acceptable |
| 16 | Table 5, #16 | 203 | hard | Translucent | Marginal, poor |
| 17 | Table 5, #17 | 163 | hard | Translucent | Complete (excellent) |
| 18 | Table 5, #18 | 171 | hard | Translucent | Complete (excellent) |
| 19 | Table 5, #19 | 183 | hard | Translucent | Complete (excellent) |
| 20 | Table 5, #20 | 180 | hard | Translucent | Complete (excellent) |
| 21 | Table 5, #21 | 177 | hard | Translucent | Complete (excellent) |
| 22 | Table 5, #22 | 160 | hard | Translucent | Complete (excellent) |

| | | | | | |
|---|---|---|---|---|---|
| * T_{g} refers to the glass transition temperature of a given material cured under standard reflow conditions as measured by DSC. ** B-stage corresponds to the state of the film after solvent removal. *** Based on a visual inspection of the film after solvent removal. Clear is used to designate the best clarity, Translucent is used to designate acceptable clarity for this application (i.e. no adverse effects on wafer dicing process) and opaque is used to designate unacceptable clarity. **** Based on visual inspection during and after heating at 200-240°C. | | | | | |

The results of Table 6 indicate that the base resin (entry 1) exhibits good flow as shown by excellent solder ball collapse; however, this resin has an unacceptably high CTE value and would be expected to give poor reliability when used as a wafer level underfill in flip-chip devices. The use of conventional 5 micron filler (entry 2) gives lower CTE while preserving excellent solder ball collapse but leads to a loss of transparency required for wafer dicing operations. The use of 20 nm filled systems gives excellent transparency but leads to a loss in flow as shown by unacceptably poor solder ball collapse (entry 3) at a filler loading comparable to that used with the 5 micron filler. Good solder ball collapse is observed at 10% SiO₂ 20 nm filler but not at greater than 15% SiO₂ 20 nm filler (entries 3and 4 respectively). Use of 50 nm filler (Table 4, entries 6 and 7) show a substantial increase in flow as shown by good solder ball collapse at up to 30 weight percent filler. Furthermore, addition of a cycloaliphatic epoxy resin to the formulations provides both a substantial gain in flow as well as better film transparency with a similar result being obtained with addition of aliphatic epoxy resins (Table 6, entries 8-11 and 17-18 respectively). Furthermore, similar improvements in flow are also realized with combinations of 50nm filler and monomeric hardeners that include some dihydroxy compounds (Table 6, entries 19-22).
Although preferred and other embodiments of the invention have been described herein, further embodiments may be perceived by those skilled in the art without departing from the scope of the invention as defined by the following claims.

## Claims

1. A transparent composition comprising at least one curable aromatic epoxy resin, at least one solvent, a filler of colloidal silica the colloidal silica functionalized with an organoalkoxysilane, and at least one selected from the group consisting of cycloaliphatic epoxy monomer, aliphatic epoxy monomer, hydroxy aromatic compounds, and combinations and mixtures thereof, and at least one selected from the group consisting of epoxy resins, acrylate resins, polyimide resins, fluorocarbon resins, fluororesins, benzocyclobutene resins, bismaleimide triazine resins, fluorinated polyallyl ethers, polyamide resins, polyimidoamide resins, phenol cresol resins aromatic polyester resins, polyphenylene ether resins and polydimethyl siloxane resins, wherein the said filler has a particle size of from 50nm to 100nm.

2. The composition of claim 1, wherein the composition further comprises additives selected from the group consisting of flame retardants, adhesion promoters, reactive organic diluents, curing agents, and combinations thereof.

3. The composition of claim 1, wherein the resin further comprises at least one silicone-epoxy resin.

4. The composition of claim 1, wherein the aromatic epoxy resin is a cresol-novolac epoxy.

5. The composition of claim 1, wherein the at least one cycloaliphatic epoxy monomer is selected from the group consisting of 3-cyclohexenylmethyl-3-cyclohexenylcarboxylate diepoxide, 3-(1,2-epoxyethyl)-7-oxabicycloheptane; hexanedioic acid, bis(7-oxabicyclo hept-ylmethyl) ester; 2-(7-oxabicyclohept-3-yl)-spiro(1,3-dioxa-5,3'-(7)-oxabicycloheptane; and methyl 3,4-epoxycyclohexane carboxylate.

6. The composition of claim 1, wherein the at least one aliphatic epoxy monomer is selected from the group consisting of butadiene dioxide, dimethylpentane dioxide, diglycidyl ether, 1, 4-butanedioldiglycidyl ether, diethylene glycol diglycidyl ether, and dipentene dioxide.

7. The composition of claim 1, wherein the colloidal silica is functionalized with phenyl trimethoxysilane.

8. The transparent underfill composition of claim 1, wherein the colloidal silica is endcapped by a silylating agent.

9. The transparent underfill composition of claim 13, wherein the silylating agent is hexamethyldisilazane.

10. The composition of claim 1, wherein the filler of colloidal silica further comprises silicon dioxide in an amount ranging from about 15 weight percent to about 75 weight percent of the composition.

11. The composition of claim 1, wherein the composition further comprises a catalyst selected from the group consisting of triphenyl phosphine; N-methylimidazole, and butyl tin dilaurate.

12. A transparent underfill composition comprising a cresol novolac epoxy resin; at least one selected from the group consisting of cycloaliphatic epoxy resin, aliphatic epoxy resin, hydroxy aromatic compounds, and mixtures and combinations thereof; at least one solvent; a functionalized colloidal silica dispersion having a particle size of 50 nm to 100 nm; and at least one catalyst.

13. A solid state device comprising:
a chip;
a substrate; and
a transparent curable underfill composition between the chip and the substrate comprising at least one aromatic epoxy resin, a functionalized colloidal silica dispersion, and at least one selected from the group consisting of cycloaliphatic epoxy monomer, aliphatic epoxy monomer, hydroxy aromatic compounds, and combinations and mixtures thereof; said functionalized colloidal silica having a particle size of 50 nanometers to 100 nanometers.

14. The solid state device according to claim 13, wherein the said transparent curable underfiller comprises a solvent.

15. The solid state device of claim 13 wherein the transparent underfill composition further comprises additives selected from the group consisting of resin hardeners, resin catalysts, flame retardants, adhesion promoters, reactive organic diluents, curing agents, and combinations thereof.

16. A method for producing a transparent underfill composition comprising:
functionalizing colloidal silica such that a stable concentrated dispersion of colloidal silica having a particle size of 50 nm to 100 nm is formed;
forming a concentrated dispersion of functionalized colloidal silica containing 15 weight percent to 75 weight percent silica;
blending solutions of an aromatic epoxy resin, at least one selected from the group consisting of cycloaliphatic epoxy monomer, aliphatic epoxy monomer, hydroxyl aromatic compounds, and mixtures and combinations thereof; and a solvent with the functionalized colloidal silica dispersion;
removing the solvent to form a hard, transparent B-stage resin film; and
curing the transparent B-stage resin film.

17. The method of claim 16 wherein the step of forming a concentrated dispersion of functionalized colloidal silica comprises placing the functionalized colloidal silica at a temperature ranging from about 20°C. to about. 140°C. under a vacuum ranging from about 0.5 Torr to about 250 Torr.

18. The method of claim 17 wherein the step of blending solutions of epoxy monomers and solvent with the functionalized colloidal dispersion further comprises adding to the solution of epoxy monomer an additive selected from the group consisting of selected from the group consisting of hardeners, reactive organic diluents, curing agents, and combinations thereof.

19. The method of claim 16 wherein the step of curing the transparent B-stage resin film comprises placing the B-stage resin film at a temperature ranging from about 50°C to about 250°C in a vacuum at a pressure ranging from about 75 mmHg to about 250mmHg.

## Patentansprüche

1. Transparente Zusammensetzung, welche umfasst: mindestens ein härtbares aromatisches Epoxidharz, mindestens ein Lösungsmittel, einen Füllstoff aus kolloidalem Silika, wobei das kolloidale Silika mit einem Organoalkoxysilan funktionalisiert ist, und mindestens eines ausgewählt aus der Gruppe bestehend aus cycloaliphathischem Epoxidmonomer, aliphatischem Epoxidmonomer, aromatischen Hydroxyverbindungen und Kombinationen sowie Gemischen derselben, und mindestens eines ausgewählt aus der Gruppe bestehend aus Epoxidharzen, Acrylatharzen, Polyimidharzen, Fluorkohlenwasserstoffharzen, Fluorharzen, Benzocyclobutenharzen, Bismaleimidtriazinharzen, fluorierten Polyallylethern, Polyamidharzen, Polyimidoamidharzen, Phenolkresolharzen, aromatischen Polyesterharzen, Polyphenylenetherharzen und Polydimethylsiloxanharzen, wobei der Füllstoff eine Partikelgröße von 50 nm bis 100 nm aufweist.

2. Zusammensetzung nach Anspruch 1, **dadurch gekennzeichnet, dass** die Zusammensetzung weiterhin Zusätze ausgewählt aus der Gruppe bestehend aus Flammschutzmitteln, Adhäsionsbeschleunigern, reaktiven organischen Verdünnungsmitteln, Härtungsmitteln und Kombinationen derselben umfasst.

3. Zusammensetzung nach Anspruch 1, **dadurch gekennzeichnet, dass** das Harz weiterhin mindestens ein Silicon-Epoxidharz umfasst.

4. Zusammensetzung nach Anspruch 1, **dadurch gekennzeichnet, dass** das aromatische Epoxidharz ein Kresol-Novolak-Epoxid ist.

5. Zusammensetzung nach Anspruch 1, **dadurch gekennzeichnet, dass** das mindestens eine cycloaliphatische Epoxidmonomer aus der Gruppe bestehend aus 3-Cyclohexenylmethyl-3-cyclohexenylcarboxylatdiepoxid, 3-(1,2-Epoxyethyl)-7-oxabicycloheptan; Hexandisäure, Bis(7-oxabicyclo-heptylmethyl)ester; 2-(7-Oxabicyclohept-3-yl)-spiro(1,3-dioxa-5,3'-(7)-oxabicycloheptan; und Methyl-3,4-Epoxycyclohexancarboxylat ausgewählt ist.

6. Zusammensetzung nach Anspruch 1, **dadurch gekennzeichnet, dass** das mindestens eine aliphatische Epoxidmonomer aus der Gruppe bestehend aus Butadiendioxid, Dimethylpentandioxid, Diglycidylether, 1,4-Butandioldiglycidylether, Diethylenglycoldiglycidylether und Dipentendioxid ausgewählt ist.

7. Zusammensetzung nach Anspruch 1, **dadurch gekennzeichnet, dass** das kolloidale Silika mit Phenyltrimethoxysilan funktionalisiert ist.

8. Transparente Unterfüllzusammensetzung nach Anspruch 1, **dadurch gekennzeichnet, dass** das kolloidale Silika durch ein Silylierungsmittel endgruppengeschützt ist.

9. Transparente Unterfüllzusammensetzung nach Anspruch 13, **dadurch gekennzeichnet, dass** das Silylierungsmittel Hexamethyldisilazan ist.

10. Zusammensetzung nach Anspruch 1, **dadurch gekennzeichnet, dass** der Füllstoff aus kolloidalem Silika weiterhin Siliziumdioxid in einer Menge von etwa 15 Gewichtsprozent bis etwa 75 Gewichtsprozent der Zusammensetzung umfasst.

11. Zusammensetzung nach Anspruch 1, **dadurch gekennzeichnet, dass** die Zusammensetzung weiterhin einen Katalysator ausgewählt aus der Gruppe bestehend aus Triphenylphosphin, N-Methylimidazol und Butyl-Zinndilaurat umfasst.

12. Transparente Unterfüllzusammensetzung, welche umfasst: ein Kresol-Novolak-Epoxidharz; mindestens eines ausgewählt aus der Gruppe bestehend aus cycloaliphatischem Epoxidharz, aliphatischem Epoxidharz, aromatischen Hydroxyverbindungen und Gemischen sowie Kombinationen derselben; mindestens ein Lösungsmittel; eine funktionalisierte kolloidale Silika-Dispersion mit einer Partikelgröße von 50 nm zu 100 nm; und mindestens einen Katalysator.

13. Festkörpervorrichtung, welche umfasst:
einen Chip;
ein Substrat; und
eine transparente härtbare Unterfüllzusammensetzung zwischen dem Chip und dem Substrat, welche umfasst: mindestens ein aromatisches Epoxidharz, eine funktionalisierte kolloidale Silika-Dispersion und mindestens eines ausgewählt aus der Gruppe bestehend aus cycloaliphatischem Epoxidmonomer, aliphatischem Epoxidmonomer, aromatischen Hydroxyverbindungen und Kombinationen sowie Gemischen derselben, wobei das funktionalisierte kolloidale Silika eine Partikelgröße von 50 Nanometer bis 100 Nanometer aufweist.

14. Festkörpervorrichtung nach Anspruch 13, **dadurch gekennzeichnet, dass** er transparente härtbare Unterfüller ein Lösungsmittel umfasst.

15. Festkörpervorrichtung nach Anspruch 13, **dadurch gekennzeichnet, dass** die transparente Unterfüllzusammensetzung weiterhin Zusätze ausgewählt aus der Gruppe bestehend aus Harzhärtern, Harzkatalysatoren, Flammschutzmitteln, Adhäsionsbeschleunigern, reaktiven organischen Verdünnungsmitteln, Härtungsmitteln und Kombinationen derselben umfasst.

16. Verfahren zum Herstellen einer transparenten Unterfüllzusammensetzung, welches umfasst:
Funktionalisieren von kolloidalem Silika, so dass eine stabile konzentrierte Dispersion von kolloidalem Silika mit einer Partikelgröße von 50 nm bis 100 nm gebildet wird;
Bilden einer konzentrierten Dispersion von funktionalisiertem kolloidalem Silika, das 15 Gewichtsprozent bis 75 Gewichtsprozent Silika enthält;
Mischen von Lösungen eines aromatischen Epoxidharzes, mindestens eines ausgewählt aus der Gruppe bestehend aus cycloaliphatischem Epoxidmonomer, aliphatischem Epoxidmonomer, aromatischen Hydroxylverbindungen und Gemischen sowie Kombinationen derselben; und einem Lösungsmittel mit der funktionalisierten kolloidalen Silika-Dispersion;
Entfernen des Lösungsmittels, um einen harten, transparenten B-Zustands-Film zu bilden; und
Aushärten des transparenten B-Zustands-Films.

17. Verfahren nach Anspruch 16, **dadurch gekennzeichnet, dass** der Schritt des Bildens einer konzentrierten Dispersion von funktionalisiertem kolloidalen Silika das Setzen des funktionalisierten kolloidalen Silika bei einer Temperatur in einem Bereich von etwa 20°C bis etwa 140°C unter ein Vakuum in einem Bereich von etwa 0,5 Torr bis etwa 250 Torr umfasst.

18. Verfahren nach Anspruch 17, **dadurch gekennzeichnet, dass** der Schritt des Mischens von Lösungen aus Epoxidmonomeren und Lösungsmittel mit der funktionalisierten kolloidalen Dispersion weiterhin umfasst: das Hinzugeben eines Zusatzes ausgewählt aus der Gruppe bestehend aus Härtern, reaktiven organischen Verdünnungsmitteln, Härtungsmitteln und Kombinationen derselben zu der Lösung von Epoxidmonomer.

19. Verfahren nach Anspruch 16, **dadurch gekennzeichnet, dass** der Schritt des Härtens des transparenten B-Zustands-Harzfilms das Setzen des B-Zustands-Harzfilms bei einer Temperatur in einem Bereich von etwa 50°C bis etwa 250°C in ein Vakuum bei einem Druck in einem Bereich von etwa 75 mmHg bis etwa 250 mmHg umfasst.

## Revendications

1. Composition transparente comprenant au moins une résine époxy aromatique durcissable, au moins un solvant, une charge de silice colloïdale, la silice colloïdale étant fonctionnalisée avec un organoalcoxysilane, et au moins un sélectionné dans le groupe consistant en monomère époxy cycloaliphatique, monomère époxy aliphatique, composés hydroxy aromatiques et leurs combinaisons et mélanges, et au moins un sélectionné dans le groupe consistant en résines époxy, résines acrylate, résines polyimide, résines fluorocarbone, fluororésines, résines benzocyclobutène, résine bismaléïmide triazine, éthers polyallyl fluorés, résines polyamide, résines polyimidoamide, résine phénol crésol, résines polyester aromatique, résines polyphénylène éther et résines polydiméthyl siloxane, où ladite charge a une taille de particule de 50 nm à 100 nm.

2. Composition selon la revendication 1, où la composition comprend en outre des additifs sélectionnés dans le groupe consistant en retardateurs de flamme, promoteurs d'adhésion, diluants organiques réactifs, agents de durcissement et leurs combinaisons.

3. Composition selon la revendication 1, où la résine comprend en outre au moins une résine silicone-époxy.

4. Composition selon la revendication 1, où la résine époxy aromatique est un époxy crésol-novolac.

5. Composition selon la revendication 1, dans laquelle le au moins un monomère époxy cycloaliphatique est sélectionné dans le groupe consistant en 3-cyclohexenylméthyl-3-cyclohexènylcarboxylate diépoxyde, 3-(1,2-époxyéthyl)-7-oxabicycloheptane; acide hexanedioïque, bis(7-oxabicyclo hept-ylméthyl) ester; 2-(7-oxabicyclohept-3-yl)-spiro(1,3-dioxa-5,3'-(7)-oxabicycloheptane et méthyl 3,4-époxycyclohexane carboxylate.

6. Composition selon la revendication 1, où le au moins un monomère époxy aliphatique est sélectionné dans le groupe consistant en butadiène dioxyde, diméthylpentane dioxyde, diglycidyl éther, 1,4-butanedioldiglycidyl éther, diéthylène glycol diglycidyl éther et dipentène dioxyde.

7. Composition selon la revendication 1, où la silice colloïdale est fonctionnalisée avec du phényl triméthoxysilane.

8. Composition transparente de sous-charge selon la revendication 1, où la silice colloïdale est coiffée en extrémité par un agent de silylation.

9. Composition transparente de sous-charge selon la revendication 13, où l'agent de silylation est l'hexaméthyldisilazane.

10. Composition selon la revendication 1, dans laquelle la charge de silice colloïdale comprend en outre du silice en une quantité d'environ 15% en poids à environ 75 pour cent en poids de la composition.

11. Composition selon la revendication 1, où la composition comprend en outre un catalyseur sélectionné dans le groupe consistant en triphényl phosphine, N-méthylimidazole et butyl étain dilaurate.

12. Composition transparente de sous-chargee comprenant une résine époxy crésol novolac; au moins un sélectionné dans le groupe consistant en résine époxy cycloaliphatique, résine époxy aliphatique, composés hydroxy aromatiques et leurs mélanges et combinaisons; au moins un solvant; une dispersion de silice colloïdale fonctionnalisée ayant une taille de particule de 50 nm à 100 nm; et au moins un catalyseur.

13. Dispositif d'état solide comprenant:
une puce;
un substrat; et
une composition transparente de sous-charge durcissable entre la puce et le substrat comprenant au moins une résine époxy aromatique, une dispersion de silice colloïdale fonctionnalisée et au moins un sélectionné dans le groupe consistant en monomère époxy cycloaliphatique, monomère époxy aliphatique, composés hydroxy aromatiques et leurs combinaisons et mélanges; ladite silice colloïdale fonctionnalisée ayant une taille de particule de 50 nanomètres à 100 nanomètres.

14. Dispositif d'état solide selon la revendication 13, dans lequel ladite sous-charge transparente durcissable comprend un solvant.

15. Dispositif d'état solide selon la revendication 13, dans lequel ladite composition transparente de sous-charge comprend en outre des additifs sélectionnés dans le groupe consistant en durcisseurs de résine, catalyseurs de résine, retardateurs de flammes, promoteurs d'adhésion, diluants réactif organiques, agents de durcissement et leurs combinaisons.

16. Procédé de fabrication d'une composition de sous-charge transparente comprenant:
fonctionnaliser de la silice colloïdale de façon qu'une dispersion concentrée stable de silice colloïdale d'une taille de particule de 50 nm à 100 nm soit formée;
former une dispersion concentrée de silice colloïdale fonctionnalisée contenant 15 pour cent à 75 pour cent en poids de silice;
mélanger des solutions d'une résine époxy aromatique, au moins un sélectionné dans le groupe consistant en monomères époxy cycloaliphatiques, monomère époxy aliphatique, composés hydroxyle aromatiques et leurs mélanges et combinaisons; et un solvant avec la dispersion de silice colloïdale fonctionnalisée;
retirer le solvant pour former un film de résine dur, transparent de stade B; et
durcir le film de résine transparent de stade B.

17. Procédé selon la revendication 16, où l'étape de formation de la dispersion concentrée de la silice colloïdale fonctionnalisée comprend le placement de la silice colloïdale fonctionnalisée à une température dans la plage d'environ 20°C à environ 140°C sous un vide dans une plage d'environ 0,5 Torr à environ 250 Torr.

18. Procédé selon la revendication 17, où l'étape de mélange des solutions de monomères époxy et de solvants avec la dispersion colloïdale fonctionnalisée comprend en outre l'ajout à la solution de monomère époxy d'un additif sélectionné dans le groupe consistant en durcisseurs, diluants organiques réactifs, agents de durcissement et leurs combinaisons.

19. Procédé selon la revendication 16, où l'étape de durcissement du film de résine transparent de stade B comprend le placement du film de résine de stade B à une température s'étendant depuis environ 50°C à 250°C dans un vide sous une pression d'environ 75 mmHg à environ 250 mmHg.
